# EUROPÄISCHE PATENTANMELDUNG

(11) **EP 2 042 878 A2**
(43) Veröffentlichungstag der Anmeldung: **01.04.2009**
(21) Anmeldenummer: 08105179.9
(22) Anmeldetag: 29.08.2008
(51) Int. Cl.: G01R 1/073

(54) **Verfahren zur automatischen Ausrichtung einer Vielzahl von Messnadelspitzen**

(30) Priorität: 28.09.2007 DE 102007046447
(71) Anmelder: Siemens Aktiengesellschaft, 80333 München (DE)
(72) Erfinder: Gerhard, Detlef, 81829, München (DE)

(57) **Zusammenfassung**

Verfahren zur Justierung von mehreren gemeinsam verfahrbaren Messnadeln (3) relativ zu Wafern (11), darauf positionierten Chips oder Baugruppen, wobei die Messnadeln zum elektrischen Prüfen verfahren werden, Messnadelspitzen (4) entsprechend aufsetzen und kontaktieren, wobei mittels eines optischen Sensors die Messnadeln (3) zu einem vorgegebenen Zeitpunkt optisch auf ihre gegenseitige Lage überprüft werden, eine Ausgleichsgerade (16) durch die Messnadelspitzen (4) gelegt wird, so dass möglichst viele Messnadelspitzen darauf zu liegen kommen, und eine die Messnadeln aufnehmende Messnadelkarte (6) mit einem Stellantrieb derart um einen Winkel vor verkippt wird, dass bei einem Prüfvorgang sämtliche Messnadelspitzen gleichzeitig aufsetzen.

## Beschreibung

Die Erfindung betrifft ein Verfahren zum elektrischen Testen von Baugruppen, Chips auf Wafern oder sonstiger Komponenten, wobei das zu testende Objekt an Messnadelspitzen eines Messinstrumentes herangefahren wird, mit den Messspitzen kontaktiert wird und die Messung beginnt.

Die hauptsächliche Einsatzmöglichkeit ergibt sich im technischen Bereich von Geräten zum Inspizieren von Wafern bzw. darauf strukturierten Elementen. Beim elektrischen Wafertest werden mehrere auf einer Messspinne sitzende Messnadeln auf zur Messung vorgesehenen Kontaktpunkten, so genannten Pads, des oder der zu vermessenden Chips mechanisch aufgesetzt und anschließend wird bei elektrischer Kontaktierung die Funktion des Chips gemessen. Zum Kontaktieren wird der Wafer angehoben und gegen die Messnadeln gedrückt, bzw. es wird die die Messnadeln in der Messspinne enthaltene Vorrichtung auf den Wafer abgesenkt. Bei sogenannten Kontaktfahrten verfahren Messeinheit und Prüfling bzw. Chuck im Wesentlichen unter Beibehaltung der parallelen gegenseitigen Ausrichtung.

Es steht im Vordergrund, bei Prüfvorgängen ein gleichzeitiges Aufsetzen sämtlicher Messnadelspitzen auf die hierfür vorgesehenen Kontaktpunkte zu erreichen. Falls diese Bedingung nicht gegeben ist, treten bei den beispielsweise zu früh aufgesetzten Messnadeln höhere mechanische Spannungen auf als bei den zum Schluss aufgesetzten Messnadeln. Gefordert ist jeweils die Kontaktierung sämtlicher Messnadeln einer Gruppe bei einer Messung. Somit kann im schlechtesten Fall ein Nadelausfall stattfinden, indem eine der zu früh aufgesetzten Nadeln mechanisch bricht. Bei einer Überdehnung von Messnadeln können auch Schädigungen der Chipoberfläche entstehen. Schlecht justierte Messspinnen erfordern eine längere Kontaktfahrt, d. h. einen längeren Weg, bis der Kontakt aller Messnadeln hergestellt ist.

Durch längere Verfahrwege der zu kontaktierenden Partner ist eine entsprechend größere Zeit für derartige Kontaktfahrten einzurechnen. Gut justierte Messnadeln erfordern kürzere Wege und es wird jede Kontaktfahrt kürzer sein, wenn die entsprechenden Justierungen exakt ausgeführt sind oder reproduzierbar für eine Vielzahl von Testvorgängen abrufbar sind. Somit wird die Summe der Messzeiten für den gesamten Wafertest bzw. für die Vielzahl von prozessierten Elementen verkürzt.

Bisher war es notwendig, dass in bestimmten zeitlichen Intervallen Messnadeln unter einem Mikroskop manuell einzujustieren waren, so dass der Einbau einer Messspinne in ein entsprechendes Prüfsystem und entsprechend weitere Apparaturen zu einer optimalen Ausrichtung der Messnadelspitzen führte. Zusätzlich konnte der Weg zur Kontaktierung zwischen Messnadelspitzen und elektronischem Bauelement mit einem Übermaß versehen sein, so dass sichergestellt ist, dass bei nicht optimaler Ausrichtung der Messnadeln auch die am weitesten vom elektronischen Bauelement entfernte Messnadel kontaktiert wird. Dies ist jedoch mit dem Nachteil verbunden, dass die zuerst kontaktierte Nadel bis zum Abschluss des Vorgangs mit einer wesentlichen Kraft angedrückt wird, die unter Umständen zum Bruch einer Nadel führen kann.

Der Erfindung liegt die Aufgabe zugrunde, ein Verfahren zum Inspizieren von Baugruppen, Chips oder Wafern bereitzustellen, mit dem ein optimales Aufsetzen sämtlicher Messnadeln auf zu prüfenden Bauelementen gewährleistet ist.

Die Lösung dieser Aufgabe geschieht durch die Merkmalskombination entsprechend Patentanspruch 1. Vorteilhafte Ausgestaltungen können den Unteransprüchen entnommen werden.

Der Erfindung liegt die Erkenntnis zugrunde, dass bei automatisch erkannter Nadelverkippung bzw. Fehlpositionierung von Messnadelspitzen, Abhilfe mittels einer Vor-Verkippung der betrachteten Gruppe von Messnadeln zur Verfügung steht, bevor die elektrische Prüfung an einer Vielzahl von Elementen beginnt. Nicht optimale Einstellungen der Position von einer oder mehreren Messnadeln, die an einer Messspinne angebracht sind, führen zu den oben genannten Nachteilen. Durch optimale Einstellung wird insbesondere das Weg-Zeit-Verhalten verkürzt und so genannte Kontaktfahrten, d. h. die Bewegungen zwischen zu prüfenden Bauelement und Prüfapparatur werden optimiert. Weiterhin wird die Wahrscheinlichkeit eines Nadelbruches minimiert, indem eine möglichst gleichmäßige mechanische und auch elektrische Belastung von Nadel zu Nadel vorliegt. Weiterhin werden Chipausfälle reduziert und der Messnadelverschleiß wird ebenfalls gesenkt.

Die Prüfung bezieht sich auf die Lage der Messnadelspitzen und unter Umständen zugleich auf die Messnadelstellungen, bevor diese Einheit des Messsystems zu einem Prüfvorgang eingesetzt wird. Idealerweise sollten die Messnadelspitzen auf einer Geraden liegen, die derart ausgerichtet ist, dass bei gegenseitigem Zusammenfahren von Messsystemen bzw. Messnadelspitzen und Prüfling in Form von Wafer, Chip oder Baugruppe sämtliche Messnadelspitzen gleichzeitig auf entsprechenden Kontaktstellen aufsetzen.

Es ist besonders vorteilhaft für ein derartiges System, eine zweidimensional auflösende CCD-Kamera einzusetzen. Eine Optimierung der Objektbeleuchtung sieht vor, dass beispielsweise LED-Lichtquellen verwendet werden und insbesondere zur Beleuchtung diffuses Licht eingesetzt wird.

Bei der Verwendung des Durchlichtprinzips werden die Messnadeln bzw. die Messnadelspitzen einseitig beleuchtet und anderseitig ihr entsprechendes Bild bzw. Schatten auf dem optischen Sensor abgebildet.

Es ist vorteilhaft, eine Justierung in einer separaten Justierstation vorzunehmen, wobei ein Werkstückträger, beispielsweise ein Chuck, derart verfahren wird, dass die Messnadeln und deren Spitzen optisch abgebildet werden können. Die Justierung erfolgt dabei nicht während eines Prüfvorgangs, sondern jeweils vorher und betrifft eine Vorverkippung einer Messnadelspitze, so dass die Messnadeln bei einem Prüfvorgang möglichst alle gleichzeitig aufsetzen. Im Folgenden werden anhand von begleitenden Figuren Ausführungsbeispiele beschrieben.
- Figur 1 zeigt: eine Messnadelspinne mit Messnadeln,
- Figur 2 zeigt: eine Messplatte, die eine darin verkippbar gelagerte Messnadelkarte aufnimmt,
- Figur 3 zeigt: die Verkippung von Messnadeln in Bezug zu ei- ner Objektebene, beispielsweise der Oberflä- che eines zu prüfenden Wafers,
- Figur 4 zeigt: den Messaufbau zur Messung der Nadelverkip- pung.

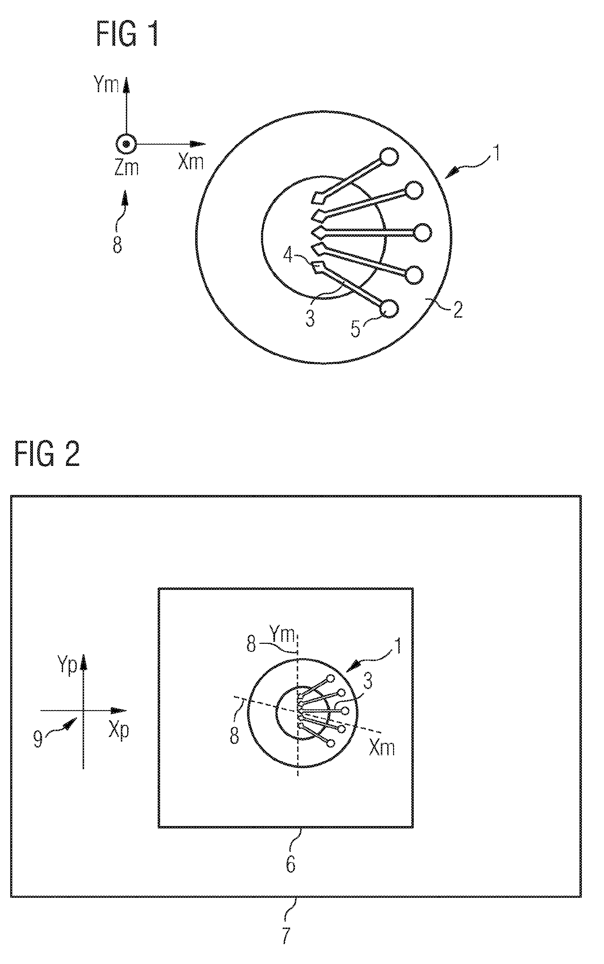

In Figur 1 ist eine Messnadelspitze 1 dargestellt, die aus einem Metall-Anschlussring 2 besteht, der Messnadeln 3 aufnimmt, wobei die Messnadeln mit ihren Messnadelspitzen in den inneren Bereich des Rings hineinragen. Die Messnadelspitzen sind in einer vorgegebenen gegenseitigen Anordnung ausgerichtet, insbesondere liegen die Messnadelspitzen 4 auf einer Geraden, einer so genannten Ausgleichsgeraden 16. Das Koordinatensystem 8 der Messnadel ist in Figur 1 angedeutet, wobei die z-Achse senkrecht auf der Bildebene steht.

Figur 2 zeigt die Messspinne 1, die in einer so genannten Messnadelkarte 6 aufgenommen ist, und wobei das Koordinatensystem 8 der Messnadeln durch unterbrochene Linien entsprechend angedeutet ist. Die Messnadelkarte 6 ist in einer Messplatte 7 aufgenommen, deren Koordinatensystem 9 mit den Koordinaten xp und yp in Figur 2 dargestellt ist. Der Metallanschlussring 2 bzw. die Messspinne 1 kann innerhalb der Messnadelkarte 6 zusätzlich verdreht werden.

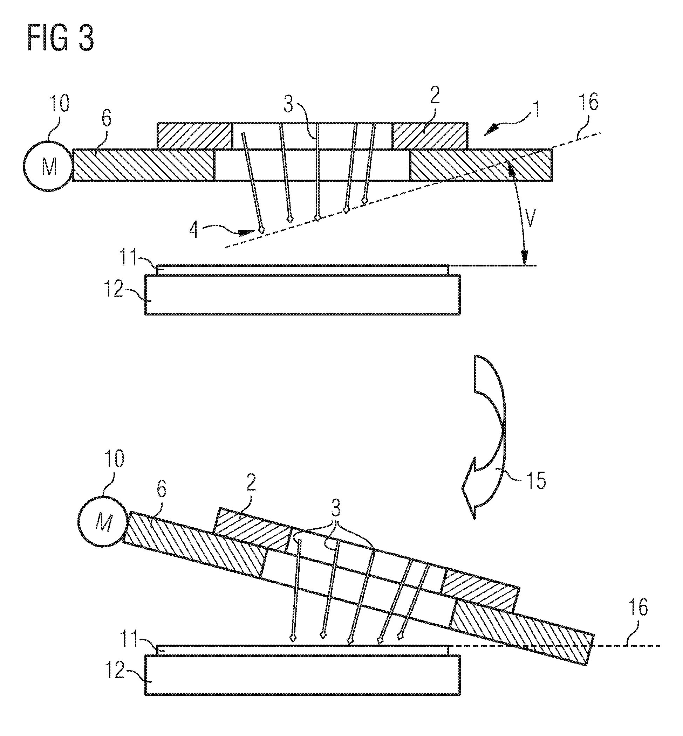

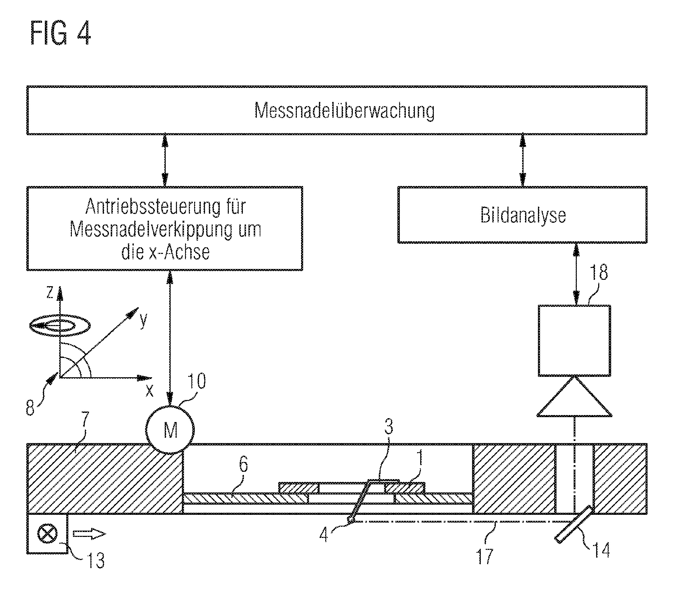

Die Figuren 3 und 4 stellen prinzipiell die Vorverkippung der Messnadeln bzw. die Ausrichtung einer Ausgleichsgeraden 16 in Bezug auf eine Chuckebene dar. Figur 4 zeigt den Messaufbau zur Messung der Nadelverkippung.

In Figur 3 ist die Anordnung von Messnadelkarte 6 und Messspinne 1 mit entsprechendem Metallanschlussring 2 und den darin enthaltenen Messnadeln 3 in der seitlichen, teilweise geschnittenen Ansicht dar. Weiterhin ist ein Motor 10, der an der Messnadelkarte 6 befestigt ist, vorhanden, so dass diese Messnadelkarte 6 mittels des Motors um eine Achse drehbar ist. Motor 10 und Messnadelkarte 6 sind in der Messplatte aufgenommen. Die Messplatte 7 ist allgemein parallel zum Werkstückträger mit darauf befindlichem Messobjekt, beispielsweise einem Wafer 11, verfahrbar.

Liegt die durch die Messnadelspitzen 4 gelegte oder konstruierte Ausgleichsgerade 16 nicht parallel zur Werkstückoberfläche, so liegt eine Verkippung vor und es wird zum Ausgleich eine entgegen gerichtete Verkippung 15 eingebracht und durch den Motor 10 entsprechend ausgeführt, damit die Messnadelspitzen bei Prüfvorgängen möglichst gleichzeitig auf der Oberfläche eines Prüfobjektes aufsetzen.

Figur 4 zeigt das Gesamtsystem in der Übersicht, wobei eine so genannte Messnadelüberwachung einerseits das Antriebssystem für die Messnadelverkippung überwacht und zugleich Daten von einer Bildanalyse aufnimmt. Die Bildanalyse greift auf Daten des optischen Sensors, insbesondere einer zweidimensional auflösenden Kamera 18 zurück, die Teil des optischen Sensors ist. Mit angedeutet ist das Koordinatensystem 8 der Messnadeln 3. Der optische Sensor weist eine Beleuchtung 13 auf, die die Messnadeln 4 im Durchlichtsystem mittels eines Messstrahls 17 und über einen Umlenkspiegel 14 in der Kamera 18 abbilden. Die Bildanalyse ergibt Daten für die Prüfung ob eine Verkippung vorliegt, was gleichzeitig Grundlage für die gegenseitige Lage der Messnadelspitzen 4 relativ zu einer Ausgleichsgeraden 16 ist.

Es werden zu einem definierten Zeitpunkt überprüft, beispielsweise im Rahmen eines Messprogramms oder eines Justierprogramms werden definiert, mit Hilfe eines optischen zweidimensionalen Messsystems wird die Messnadelstellung und die Lage der Messnadelspitzen im Prüfsystem analysiert und es wird ein Korrekturwinkel berechnet. Die Messkarte 6 mit der darauf sitzenden Messspinne und den zugehörigen Messnadeln wird automatisch mit mindestens einem Stellantrieb um den Korrekturwinkel bzw. Verkippungswinkel V verkippt.

Zur Einstellung einer Korrektur der Nadeln wird eine Vorverkippung eingerichtet, die bezüglich der Messnadelspitzen parallele Verhältnisse hinsichtlich der Oberfläche eines Prüflings erzeugt. Zur optischen Abbildung wird eine zweidimensional auflösende CCD-Kamera verwendet. Die Abbildung der Nadelspitzen erfolgt im Durchlichtprinzip. Hierzu ist hinter den Messnadeln eine Lichtquelle montiert, die mittels Licht emittierenden Dioden betrieben wird und diffuses Licht erzeugt.

Der Chuck 12 wird derart verfahren, dass die Messnadeln optisch abgebildet werden können. Die Justierung der Nadelverkippung erfolgt vor dem Prüfvorgang. Aufgrund der automatisch justierten Nadelverkippung lassen sich die Kontaktfahrten verkürzen. Die Chipoberflächen und die Messnadeln werden beispielsweise weniger stark belastet, was die Reduzierung von Chipausfällen zur Folge hat. Weiterhin wird der Messnadelverschleiß minimiert.

Die Verstellbereiche liegen im µm-Bereich. Im Strahlengang des optischen Sensors kann mindestens ein Umlenkspiegel enthalten sein. Maßgeblich für die parallele Ausrichtung ist die Oberfläche, beispielsweise eines Wafers oder eine Baugruppe.

Die Vorverkippung wird erst vorgenommen, wenn die Bildaufnahme nicht parallele Verhältnisse festgestellt hat.

## Patentansprüche

1. Verfahren zur Justierung von mehreren gemeinsam verfahrbaren Messnadeln (3) relativ zu Wafern (11), darauf positionierten Chips oder Baugruppen, wobei die Messnadeln zum elektrischen Prüfen verfahren werden, Messnadelspitzen (4) entsprechend aufsetzen und kontaktieren,
**dadurch gekennzeichnet, dass**
- mittels eines optischen Sensors die Messnadeln (3) zu einem vorgegebenen Zeitpunkt optisch auf ihre gegenseitige Lage überprüft werden,
- eine Ausgleichsgerade (16) durch die Messnadelspitzen (4) gelegt wird, so dass möglichst viele Messnadelspitzen darauf zu liegen kommen, und
- eine die Messnadeln aufnehmende Messnadelkarte (6) mit einem Stellantrieb derart um einen Winkel vorverkippt wird, dass bei einem Prüfvorgang sämtliche Messnadelspitzen gleichzeitig aufsetzen.

2. Verfahren nach Anspruch 1,
**dadurch gekennzeichnet, dass** ein optischer Sensor eine zweidimensional auflösende CCD-Kamera ist.

3. Verfahren nach Anspruch 1 oder 2,
**dadurch gekennzeichnet, dass** neben der Position der Messnadelspitzen (4) die Ausrichtung der Messnadeln (3) berücksichtigt wird.

4. Verfahren nach einem der Ansprüche 1 bis 3,
**dadurch gekennzeichnet, dass** der optische Sensor eine LED-Beleuchtung aufweist.

5. Verfahren nach einem der Ansprüche 1 bis 4,
**dadurch gekennzeichnet, dass** der optische Sensor zur Positionsprüfung mit dem Durchlichtprinzip betrieben wird.

6. Verfahren nach einem der Ansprüche 1 bis 5,
**dadurch gekennzeichnet, dass** eine Objektbeleuchtung mittels diffusem Licht geschieht.

7. Verfahren nach einem der Ansprüche 1 bis 6,
**dadurch gekennzeichnet, dass** ein Objektträger derart verfahren wird, dass Justiervorgänge in einer Justierstation ablaufen.

8. Verfahren nach einem der Ansprüche 1 bis 7,
**dadurch gekennzeichnet, dass** ein Justiervorgang vor jedem Prüfvorgang erfolgt.
